# EUROPEAN PATENT APPLICATION

(11) **EP 4 460 159 A1**
(43) Date of publication of application: **06.11.2024**
(21) Application number: 23753128.0
(22) Date of filing: 08.02.2023
(51) Int. Cl.: H05K 7/20, H05K 9/00

(54) **HEAT DISSIPATING STRUCTURE AND ELECTRONIC APPARATUS INCLUDING HEAT DISSIPATING STRUCTURE**

(30) Priority: 08.02.2022 KR 20220016488
(71) Applicant: Samsung Electronics Co., Ltd, Suwon-si, Gyeonggi-do 16677 (KR)
(72) Inventor: YOON, Jonggeun, Suwon-si, Gyeonggi-do 16677 (KR); AN, Yonghee, Suwon-si, Gyeonggi-do 16677 (KR); LIM, Sungwoo, Suwon-si, Gyeonggi-do 16677 (KR); LIM, Chankyu, Suwon-si, Gyeonggi-do 16677 (KR)
(74) Representative: HGF
(86) International application number: PCT/KR2023/001784
(87) International publication number: WO 2023/153780

(57) **Abstract**

An electronic apparatus according to various embodiments disclosed herein may comprise: a printed circuit board; an electronic component disposed on the printed circuit board; a shield can that is disposed on the printed circuit board and includes an opening facing at least a portion of the electronic component; a support structure that is disposed between the printed circuit board and the shield can and supports the shield can; a contact member that is at least partially located in the opening and covers a portion of the electronic component; a sheet member that includes a first region corresponding to the opening and a second region other than the first region and covers the contact member and the shield can; a first heat transfer member disposed on the sheet member; a second heat transfer member disposed on the sheet member and spaced apart from the first heat transfer member; a cover member covering the first heat transfer member and the second heat transfer member; and a protrusion part that overlaps the second region of the sheet member when viewed in the direction of the printed circuit board from the cover member.

## Description

### [Technical Field]

Various embodiments disclosed herein relate to a heat dissipation structure and an electronic apparatus including a heat dissipation structure.

### [Background Art]

As technology advances, high-performance electronic components are being placed inside electronic apparatuses. Electronic components may generate heat as they operate. The heat generated in electronic components may affect their performance. For example, when heat generated in electronic components is not sufficiently dissipated to the outside of the electronic apparatus, the performance of the electronic components may deteriorate. Accordingly, various types of heat dissipation structures are being designed for electronic apparatuses to dissipate heat from electronic components to the outside of the electronic apparatuses.

### [Disclosure of Invention]

### [Technical Problem]

Electronic components that generate high heat, such as an application processor (AP), may be placed inside an electronic apparatus. In an embodiment, dissipation of heat of the electronic component may be achieved when the electronic component is in contact through a thermal interface material (TIM) with a metal structure around the electronic component. For example, heat from the electronic component may be transferred to the metal structure through the thermal interface material and spread around the metal structure.

As technology advances in electronic apparatuses, electronic components with higher performance than before may be placed inside the electronic apparatuses. Due to these circumstances, heat from the electronic components may not be sufficiently dissipated to the surroundings of the electronic components by using the existing heat dissipation structure alone.

Various embodiments disclosed herein may provide a structure for dissipating heat generated from an electronic component to the outside of an electronic apparatus. Accordingly, the heat dissipation performance of the electronic apparatus may be improved.

### [Solution to Problem]

An electronic apparatus according to various embodiments disclosed herein may include a printed circuit board, an electronic component disposed on the printed circuit board, a shield can disposed on the printed circuit board and including an opening facing at least a portion of the electronic component, a support structure disposed between the printed circuit board and the shield can and configured to support the shield can,
a contact member at least partially located in the opening and configured to cover a portion of the electronic component,
a sheet member including a first region which corresponds to the opening, and a second region other than the first region, and configured to cover the contact member and the shield can, a first heat transfer member disposed on the sheet member, a second heat transfer member disposed on the sheet member and spaced apart from the first heat transfer member, a cover member configured to cover the first heat transfer member and the second heat transfer member, and a protrusion part overlapping the second region of the sheet member when viewed in the direction of the printed circuit board from the cover member.

A heat dissipation structure according to various embodiments disclosed herein may include a shield can disposed on a printed circuit board of an electronic apparatus and including an opening facing at least a portion of the electronic component disposed on the printed circuit board, a support structure disposed between the printed circuit board and the shield can to support the shield can, a contact member at least partially located in the opening and configured to cover a portion of the electronic component, a sheet member including a first region which corresponds to the opening, and a second region other than the first region, and configured to cover the contact member and the shield can, a first heat transfer member disposed on the sheet member, a second heat transfer member disposed on the sheet member and spaced apart from the first heat transfer member, a cover member configured to cover the first heat transfer member and the second heat transfer member, and a protrusion part overlapping the second region of the sheet member when viewed in the direction of the printed circuit board from the cover member.

### [Advantageous Effects of Invention]

Various embodiments disclosed herein may provide a heat dissipation structure configured to directly transfer heat generated from an electronic component to a cover member constituting the exterior of an electronic apparatus. Accordingly, the heat from the electronic component may be released to the outside of the electronic apparatus through the cover member. Therefore, the heat dissipation performance of the electronic apparatus may be improved.

In addition, various embodiments disclosed herein may provide a heat dissipation structure by which, when an external impact is applied to the cover member, the electronic component disposed adjacent to the cover member may be protected from the external impact.

### [Brief Description of Drawings]

In relation to the description of the drawings, identical or similar reference numerals may be used for identical or similar components.
FIG. 1 is a block diagram of an electronic apparatus in a network environment, according to various embodiments.
FIG. 2A is a perspective view of the front of an electronic apparatus according to various embodiments disclosed herein.
FIG. 2B is a perspective view of the rear of the electronic apparatus of FIG. 2A according to various embodiments disclosed herein.
FIG. 3 is an exploded perspective view of the electronic apparatus of FIG. 2A according to various embodiments disclosed herein.
FIG. 4 is an exploded perspective view of a heat dissipation structure according to various embodiments disclosed herein.
FIG. 5 is a projection view of a heat dissipation structure viewed from the rear of an electronic apparatus, according to various embodiments disclosed herein.
FIG. 6A is a cross-sectional view taken along line A-A of FIG. 5.
FIG. 6B is a cross-sectional view taken along line B-B of FIG. 5.
FIG. 6C is a cross-sectional view taken along line C-C of FIG. 5.
FIG. 7A illustrates a shield can surrounding an electronic component according to various embodiments disclosed herein.
FIG. 7B is a perspective view of the rear of a shield can according to various embodiments disclosed herein.

### [Mode for the Invention]

It should be appreciated that various embodiments of the present disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

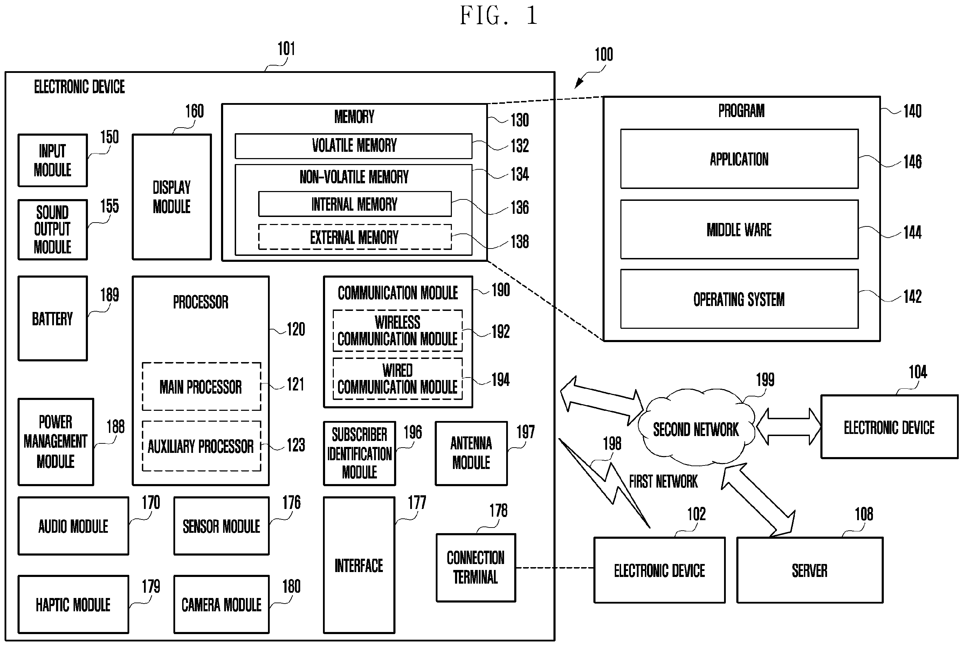

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

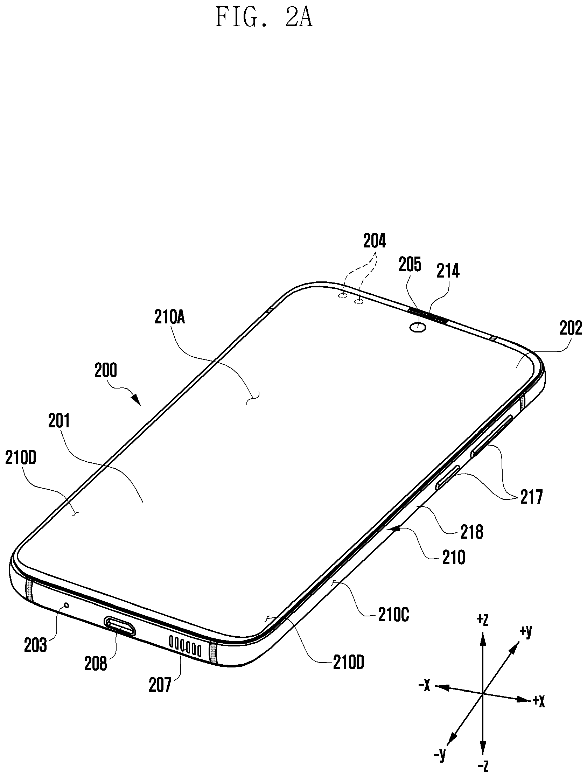

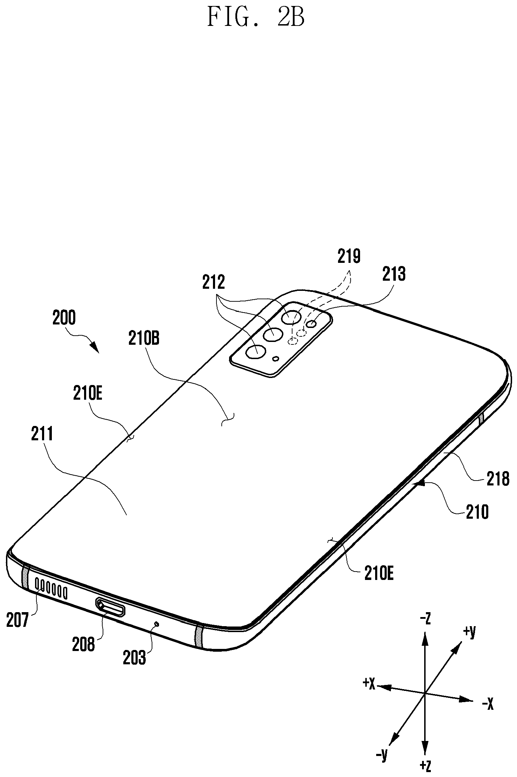

FIG. 2A is a front perspective view of an electronic device according to various embodiments of the disclosure. FIG. 2B is a rear perspective view of the electronic device of FIG. 2A according to various embodiments of the disclosure.

The electronic device 200 to be described below may include at least one of the components of the electronic device 101 described above with reference to FIG. 1.

With reference to FIG. 2A and FIG. 2B, the electronic device 200 according to an embodiment may include a housing 210 that includes a first surface (or front surface) 210A, a second surface (or rear surface) 210B, and a side surface 210C surrounding a space between the first surface 210A and the second surface 210B. According to an embodiment (not shown), the housing 210 may refer to a structure forming a part of the first surface 210A, the second surface 210B, and the side surface 210C in FIG. 2A. According to an embodiment, the first surface 210A may be formed by a front plate 202 (e.g., glass plate or polymer plate including various coating layers) whose at least a portion is substantially transparent. The second surface 210B may be formed by a rear plate 211 that is substantially opaque. The rear plate 211 may be formed by, for example, coated or tinted glass, ceramic, polymer, metal (e.g., aluminum, stainless steel (STS), or magnesium), or a combination of at least two thereof. The side surface 210C may be formed by a side bezel structure (or "side member") 218 coupled to the front plate 202 and the rear plate 211 and including a metal and/or a polymer. In a certain embodiment, the rear plate 211 and side bezel structure 218 may be integrally formed and include the same material (e.g., metal material such as aluminum).

In the illustrated embodiment, the front plate 202 may include a first region 210D that is curved and seamlessly extended from the first surface 210A toward the rear plate at opposite ends of the longer edge of the front plate 202. In the illustrated embodiment (see FIG. 2B), the rear plate 211 may include a second region 210E that is curved and seamlessly extended from the second surface 210B toward the front plate 202 respectively at opposite ends of the longer edge. In a certain embodiment, the front plate 202 or the rear plate 211 may include only one of the first region 210D and the second region 210E. In a certain embodiment, the front plate 202 may not include the first region and the second region, but may include only a flat surface disposed parallel to the second surface 210B. In the above embodiments, when the electronic device is viewed from the side thereof, the side bezel structure 218 may have a first thickness (or width) on a side where the first region 210D or the second region 210E is not included, and may have a second thickness thinner than the first thickness on a side where the first region 210D or the second region 210E is included.

According to an embodiment, the electronic device 200 may include at least one or more of display 201, input device 203, sound output devices 207 and 214, sensor modules 204 and 219, camera modules 205 and 212, key input device 217, indicator (not shown), or connector 208. In a certain embodiment, at least one of the elements (e.g., key input device 217 or indicator) may be omitted from the electronic device 200, or another element may be added to the electronic device 200.

The display 201 may be exposed, for example, through a significant portion of the front plate 202. In a certain embodiment, at least a portion of the display 201 may be exposed through the front plate 202 forming the first surface 210A and the first region 210D of the side surface 210C. The display 201 may be coupled to or disposed adj acent to a touch sensing circuit, a pressure sensor capable of measuring the intensity (pressure) of a touch, and/or a digitizer that detects a magnetic field type stylus pen. In a certain embodiment, at least some of the sensor modules 204 and 219, and/or at least some of the key input devices 217 may be disposed on the first region 210D and/or the second region 210E.

The input device 203 may include a microphone 203. In a certain embodiment, the input device 203 may include a plurality of microphones 203 arranged to detect the direction of a sound. The sound output devices 207 and 214 may include speakers 207 and 214. The speakers 207 and 214 may include an external speaker 207 and a call receiver 214. In a certain embodiment, the microphone 203, the speakers 207 and 214, and the connector 208 may be at least partially disposed in the internal space of the electronic device 200, and may be exposed to the external environment through at least one hole formed in the housing 210. In a certain embodiment, the hole formed in the housing 210 may be commonly used for the microphone 203 and the speakers 207 and 214. In a certain embodiment, the sound output devices 207 and 214 may include a speaker (e.g., piezo speaker) that operates in isolation from the hole formed in the housing 210.

The sensor modules 204 and 219 may generate an electrical signal or a data value corresponding to an internal operating state of the electronic device 200 or an external environmental state. The sensor modules 204 and 219 may include, for example, a first sensor module 204 (e.g., proximity sensor) and/or a second sensor module (not shown) (e.g., fingerprint sensor) disposed on the first surface 210A of the housing 210, and/or a third sensor module 219 (e.g., HRM(heart rat monitor) sensor) disposed on the second surface 210B of the housing 210. The fingerprint sensor may be disposed on the first surface 210A (e.g., home key button) of the housing 210, on a portion of the second surface 210B, and/or under the display 201. The electronic device 200 may further include a sensor module which is not shown, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, a proximity sensor, or an illuminance sensor.

The camera modules 205 and 212 may include a first camera module 205 disposed on the first surface 210A of the electronic device 200, a second camera module 212 disposed on the second surface 210B, and/or a flash 213. The camera modules 205 and 212 may include one or plural lenses, an image sensor, and/or an image signal processor. The flash 213 may include, for example, a light emitting diode or a xenon lamp. In a certain embodiment, two or more lenses (wide-angle lens, ultra-wide-angle lens, or telephoto lens) and image sensors may be arranged in one surface of the electronic device 200.

The key input devices 217 may be arranged in the side surface 210C of the housing 210. According to an embodiment, the electronic device 200 may not include some or all of the above-mentioned key input devices 217, and a key input device 217 not included may be implemented on the display 201 in a different form such as a soft key. According to an embodiment, the key input devices 217 may be implemented using a pressure sensor included in the display 201.

The indicator may be disposed on, for example, the first surface 210A of the housing 210. The indicator may provide, for example, state information of the electronic device 200 in a light form (e.g., light emitting element). According to an embodiment, the light emitting element may provide a light source interacting with, for example, the operation of the camera module 205. The indicator may include, for example, an LED(light emitting diode), an IR(infrared) LED, and/or a xenon lamp.

The connector holes 208 may include a first connector hole 208 capable of accepting a connector (e.g., universal serial bus (USB) connector) for transmitting and receiving power and/or data to and from an external electronic device, and/or a second connector hole (e.g., earphone jack) (not shown) capable of accepting a connector for transmitting and receiving an audio signal to and from an external electronic device.

Some of the camera modules 205 and 212, some of the sensor modules 204 and 219, or the indicator may be disposed to be exposed through the display 201. For example, the camera module 205, the sensor module 204, or the indicator may be arranged in the internal space of the electronic device 200 so as to be in contact with the external environment through an opening of the display 201 perforated up to the front plate 202 or a transmissive region. According to an embodiment, the region in which the display 201 and the camera module 205 face each other may be formed as a transmissive region having a preset transmittance as a part of the content display area. According to an embodiment, the transmissive region may be formed to have a transmittance in a range of about 5 percent to about 20 percent. This transmissive region may include a region overlapping an effective area (e.g., angle-of-view area) of the camera module 205 through which light passes for image generation with an image formed by an image sensor. For example, the transmissive region of the display 201 may include a region having a lower pixel density than surrounding regions. For example, the transmissive region may replace the opening. For example, the camera module 205 may include an under display camera (UDC). According to an embodiment, a certain sensor module 204 may be disposed in the internal space of the electronic device so as to perform its function without being visually exposed through the front plate 202. For example, in this case, the region of the display 201 facing the sensor module may not need a perforated opening.

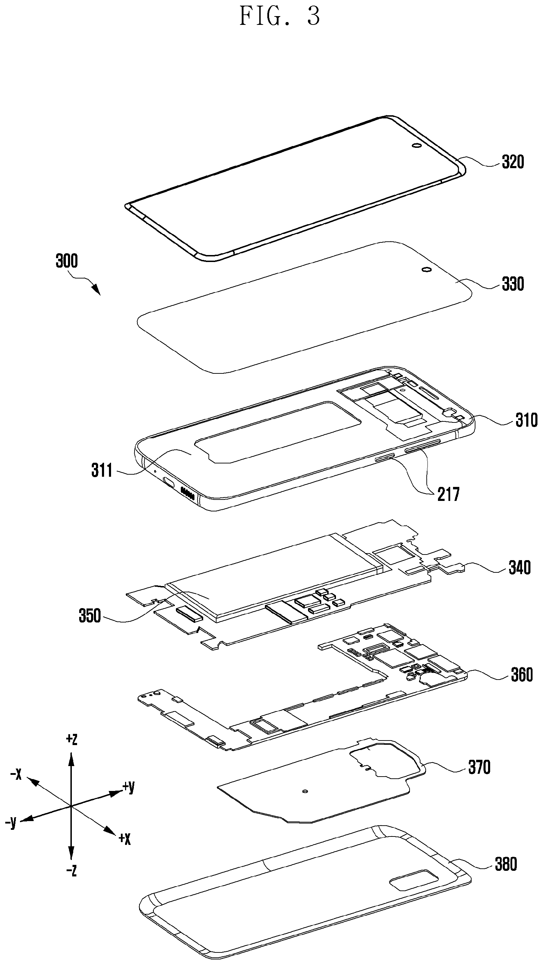

According to various embodiments, the electronic device 200 has a bar-type or platetype appearance, but the present invention is not limited thereto. In an embodiment, the disclosure may be applicable to an electronic device 200 having a foldable electronic device, a slideable electronic device, a stretchable electronic device, and/or a rollable electronic device.. "foldable electronic device", "slidable electronic device", "stretchable electronic device" and/or "rollable electronic device" This means that the display (e.g., the display 330 in FIG. 3) can be bent and deformed, so that at least part of it is folded, rolled or rolled, the area is at least partially expanded, and/or the housing It may refer to an electronic device that can be accommodated inside (e.g., the housing 210 of FIGS. 2A and 2B). Foldable electronic devices, slideable electronic devices, stretchable electronic devices, and/or rollable electronic devices expand the screen display area by unfolding the display or exposing a larger area of the display to the outside, depending on the user's needs.

FIG. 3 is an exploded perspective view of the electronic device 200 of FIG. 2A according to various embodiments of the disclosure.

The electronic device 300 of FIG. 3 may be at least partially similar to the electronic device 200 of FIGS. 2A and 2B, or may include other embodiments of an electronic device.

With reference to FIG. 3, the electronic device 300 (e.g., electronic device 200 in FIG. 2A or 2B) may include a side member 310 (e.g., side bezel structure), a first support member 311 (e.g., bracket or support structure), a front plate 320 (e.g., front cover)(e.g., front plate 202 in FIG. 2A), a display 330 (e.g., display 201 in FIG. 2A), a board 340 (e.g., printed circuit board (PCB), flexible PCB (FPCB), or rigid-flexible PCB (RFPCB)), a battery 350, a second support member 360 (e.g., rear case), an antenna 370, and a rear plate 380 (e.g., rear cover)( e.g., rear plate 211 in FIG. 2B). In a certain embodiment, at least one of the components (e.g., first support member 311 or second support member 360) may be omitted from the electronic device 300 or other components may be additionally included therein. At least one of the components of the electronic device 300 may be the same as or similar to at least one of the components of the electronic device 200 of FIG. 2A or 2B, and repeated descriptions will be omitted below.

The first support member 311 may be disposed inside the electronic device 300 and may be connected to the side member 310 or may be integrally formed with the side member 310. The first support member 311 may be made of, for example, a metal material and/or a non-metal (e.g., polymer) material. The first support member 311 may have one surface coupled to the display 330 and the other surface coupled to the board 340. A processor (e.g., processor 120 in FIG. 1), a memory (e.g., memory 130 in FIG. 1), and/or an interface (e.g., interface 177 in FIG. 1) may be mounted on the board 340. The processor may include, for example, one or more of a central processing unit, an application processor, a graphics processing unit, an image signal processor, a sensor hub processor, and a communication processor.

The memory may include, for example, a volatile memory or a non-volatile memory.

The interface may include, for example, a high definition multimedia interface (HDMI), a universal serial bus (USB) interface, an SD (secure digital) card interface, and/or an audio interface. The interface may, for example, electrically or physically connect the electronic device 300 to an external electronic device, and may include a USB connector, an SD card/MMC (multimedia card) connector, or an audio connector.

The battery 350 is a device for supplying power to at least one component of the electronic device 300, and may include, for example, a non-rechargeable primary cell, a rechargeable secondary cell, or a fuel cell. At least a portion of the battery 350 may be disposed substantially coplanar with the board 340, for example. The battery 350 may be integrally disposed inside the electronic device 300. According to an embodiment, the battery 350 may be disposed attachably and detachably with the electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may, for example, perform short-range communication with an external device or wirelessly transmit and receive power required for charging. According to an embodiment, an antenna structure may be formed by a part of the side bezel structure 310 and/or the first support member 311 or a combination thereof.

An electronic apparatus 400 described below may include at least one of the components of the electronic apparatus 101 described in FIG. 1, the electronic apparatus 200 described in FIGS. 2A and 2B, and the electronic apparatus 300 described in FIG. 3.

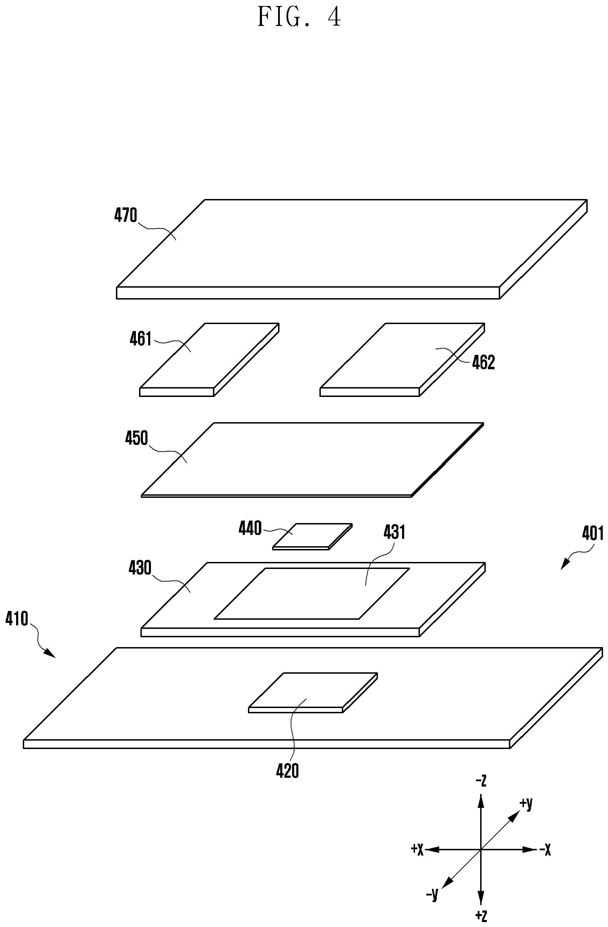

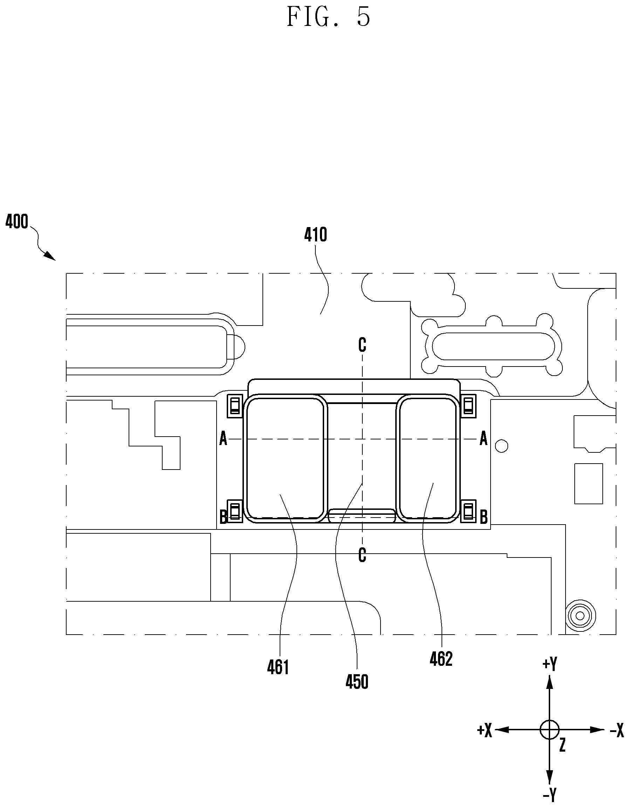

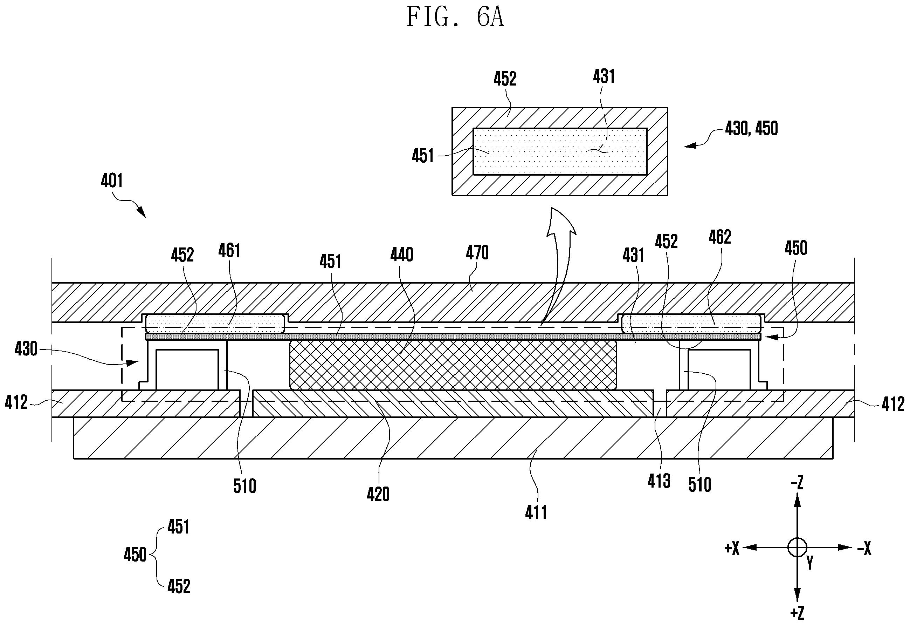

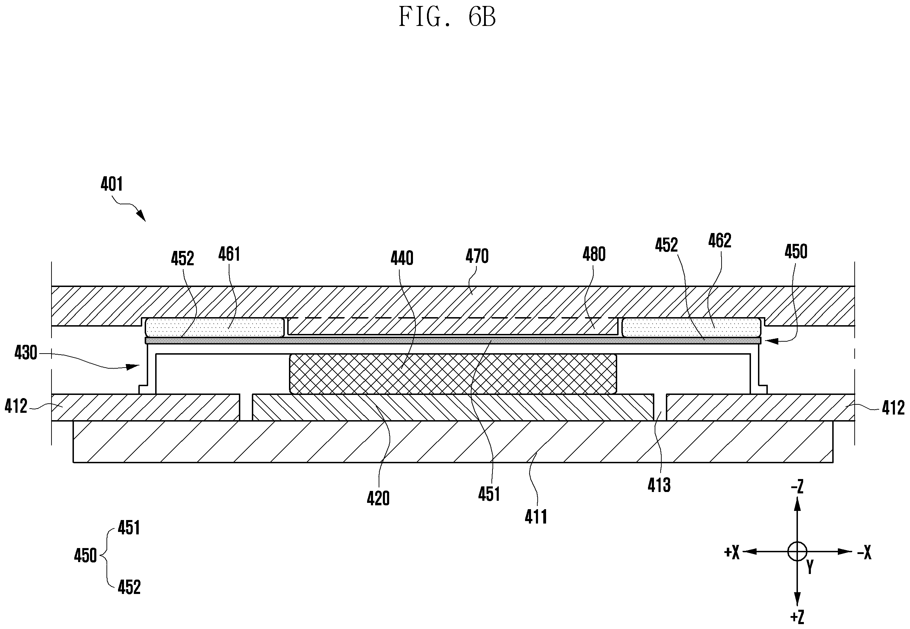

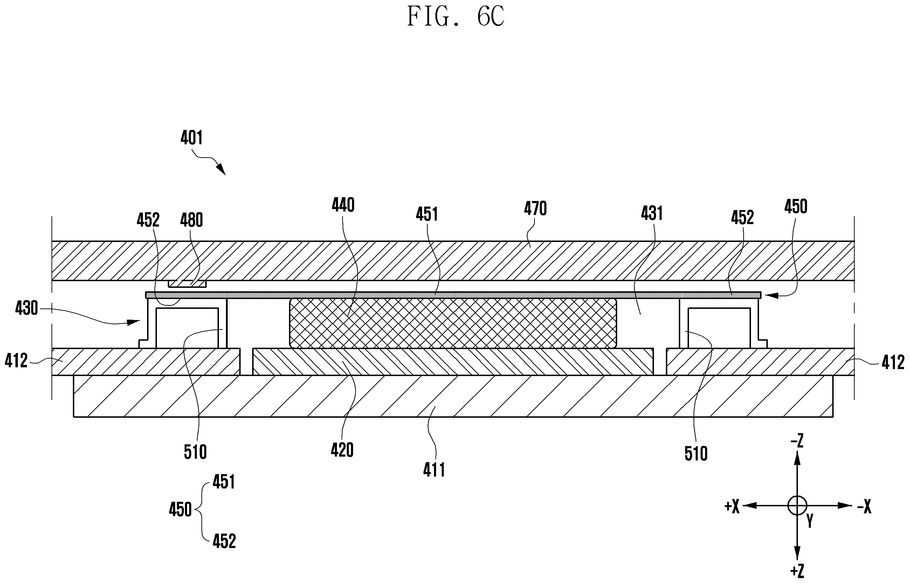

FIG. 4 is an exploded perspective view of a heat dissipation structure 401 according to various embodiments disclosed herein. FIG. 5 is a projection view of the heat dissipation structure 401 viewed from the rear of the electronic apparatus 400, according to various embodiments disclosed herein. FIG. 6A is a cross-sectional view taken along line A-A of FIG. 5. FIG. 6B is a cross-sectional view taken along line B-B of FIG. 5. FIG. 6C is a cross-sectional view taken along line C-C of FIG. 5.

According to various embodiments, the electronic apparatus 400 (e.g., the electronic apparatus 101 of FIG. 1, the electronic apparatus 200 of FIGS. 2A and 2B, and/or the electronic apparatus 300 of FIG. 3) may include electronic components 420 having various performances. The electronic component 420 may be connected to a printed circuit board 410 (e.g., the board 340 of FIG. 3) disposed within the housing to be operated electrically. Heat may be generated in the electronic component 420 according to the operation. When the heat generated in the electronic component 420 is not sufficiently dissipated to the outside of the electronic apparatus 400, the performance of the electronic component 420 may deteriorate. Accordingly, the heat dissipation structure 401 may be disposed inside the housing to diffuse heat generated by the electronic component 420 to the surroundings.

According to various embodiments, the electronic apparatus 400 may include the heat dissipation structure 401. Referring to FIG. 4, the heat dissipation structure 401 may include a shield can 430, a contact member 440, a sheet member 450, a first heat transfer member 461, a second heat transfer member 462, and a cover member 470 (e.g., the rear plate 380 of FIG. 3). In an embodiment, referring to FIG. 4, the heat dissipation structure 401 may be a structure in which the printed circuit board 410 connected to the electronic component 420, the shield can 430, the contact member 440, the sheet member 450, the first heat transfer member 461, the second heat transfer member 462, and the cover member 470 are stacked in this order. As will be described later, the heat generated in the electronic component 420 may be transferred from the electronic component 420 to the shield can 430 via the contact member 440 and the sheet member 450 to be diffused around the shield can 430. In addition, the heat generated in the electronic component 420 may be transferred from the electronic component 420 to the cover member 470 via the contact member 440, the sheet member 450, the first heat transfer member 461, and the second heat transfer member 462 to be released to the outside of the electronic apparatus 400.

According to various embodiments, the electronic component 420 may be disposed on the printed circuit board 410. As will be described later, the shield can 430 may include an opening 431 and may be disposed on the printed circuit board 410 to cover the electronic component 420. In an embodiment, at least a portion of the electronic component 420 may face the opening 431 formed through the shield can 430 when viewed in the +Z direction in FIG. 4. The other portion of the electronic component 420 except for the portion facing the opening 431 may be covered by the shield can 430 without facing the opening 431.

According to various embodiments, the shield can 430 may be disposed on the printed circuit board 410 to cover at least a portion of the electronic component 420. The shield can 430 may include the opening 431 facing at least a portion of the electronic component 420. The opening 431 may be formed through one surface of the shield can 430. One surface of the shield can 430 may include the opening 431 and a surface surrounding the opening 431. The shield can 430 may cover the electronic component 420 such that the at least a portion of the electronic component 420 faces the opening 431.

In an embodiment, the shield can 430 may be disposed on the printed circuit board 410 such that the opening 431 faces a portion of the electronic component 420 when viewed in the +Z direction in FIG. 4. In addition, the shield can 430 may be disposed on the printed circuit board 410 to cover the other portion of the electronic component 420 except for the portion facing the opening 431. In this case, the opening 431 of the shield can 430 may have a size corresponding to a portion of the electronic component 420. In some embodiments, the shield can 430 may be disposed on the printed circuit board 410 such that one surface of the electronic component 420 is fully exposed through the opening 431 when viewed in the +Z direction in FIG. 4. In this case, the opening 431 may have a size allowing the same to contain the electronic component 420.

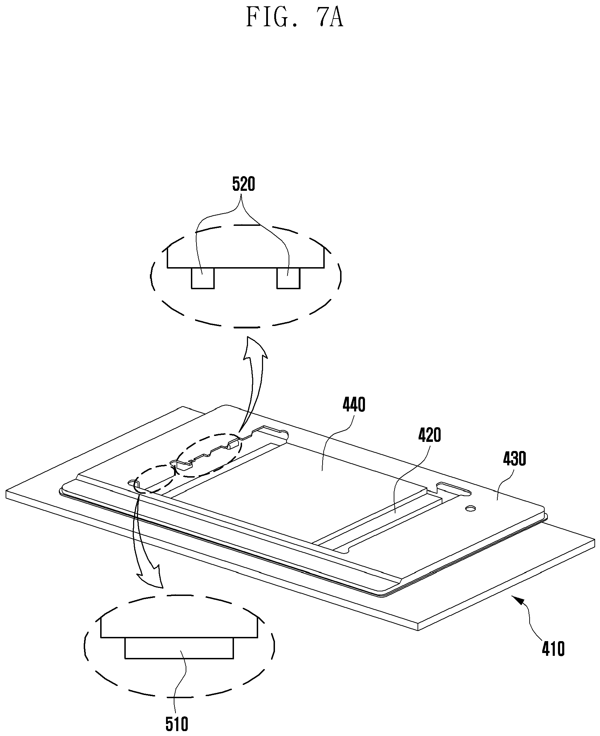

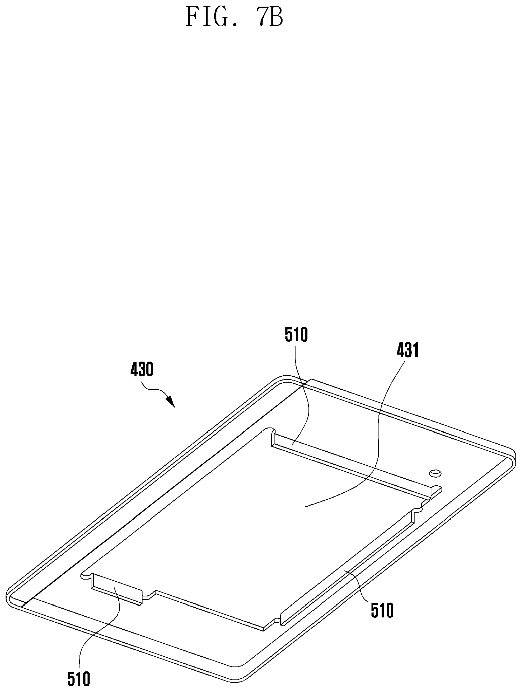

In an embodiment, a support structure 510 may be disposed between the shield can 430 and the printed circuit board 410. The support structure 510 may be disposed between the printed circuit board 410 (e.g., the second printed circuit board 412) and the shield can 430 to support the shield can 430. As will be described later, the support structure 510 may protect the shield can 430 from external impact transferred to the shield can 430 via the first heat transfer member 461 and the second heat transfer member 462. In addition, the shield can 430 may be protected from external impact transferred from the cover member 470 to a protrusion part 480. Accordingly, the shield can 430 may ensure durability against external impact through the support structure 510. The support structure 510 will be described in detail in FIGS. 7A and 7B.

In an embodiment, the shield can 430 may be formed of a conductive material to shield electromagnetic waves generated from the printed circuit board 410 and the electronic component 420 or to disperse heat generated from the electronic component 420 to the surroundings. For example, the shield can 430 may be made of a material such as metal or graphite. In addition to this, the shield can 430 may shield electromagnetic waves and be formed of various materials having heat conduction properties. In addition, the shield can 430 may be made of a material having a certain level of rigidity or higher to protect the electronic component 420 located inside the shield can 430 from external impact.

According to various embodiments, as shown in FIG. 4, the contact member 440 may be disposed on the electronic component 420. The contact member 440 may cover a portion of the electronic component 420. In an embodiment, referring to FIG. 7A, which will be described later, the contact member 440 may be disposed on a portion of the electronic component 420 and exposed through the opening 431 of the shield can 430. The contact member 440 may be disposed between the electronic component 420 and the sheet member 450 and may transfer heat generated in the electronic component 420 to the sheet member 450. In an embodiment, the contact member 440 may be made of a thermal interface material (TIM) having excellent heat conduction efficiency. In addition, the contact member 440 may be made of various materials having thermal conductivity. Furthermore, the contact member 440 may be made of a material that has not only thermal conductivity but also adhesiveness, thereby bonding the electronic component 420 and the sheet member 450 to each other.

According to various embodiments, the sheet member 450 may be disposed on the shield can 430 and cover the contact member 440 and the opening 431 of the shield can 430. Heat generated in the electronic component 420 may be transferred to the sheet member 450 via the contact member 440. The heat transferred to the sheet member 450 may be diffused around the electronic component 420 via the shield can 430 in contact with the sheet member 450. In summary, the heat generated from the electronic component 420 may be transferred from the electronic component 420 to the shield can 430 via the contact member 440 and the sheet member 450 to be released around the shield can 430.

In an embodiment, the sheet member 450 may include a first region 451 corresponding to the opening 431 of the shield can 430, and a second region 452 other than the first region 451. In an embodiment, the second region 452 may be a region corresponding to a region of one surface of the shield can 430 surrounding the opening 431. The first region 451 of the sheet member 450 may be in contact with the contact member 440. The second region 452 may be a portion supported by the shield can 430. For example, the second region 452 may be supported by the portion of one surface of the shield can 430 surrounding the opening 431. The above-mentioned first region 451 and second region 452 are merely divided to explain the relationship between the shield can 430 and the sheet member 450 for convenience of explanation, and the first region 451 and the second region 452 may be regions which are not physically divided.

In an embodiment, the sheet member 450 may be formed of a conductive material to shield electromagnetic waves generated from the printed circuit board 410 and the electronic component 420 or to disperse heat generated in the electronic component 420 to the surroundings. For example, the sheet member 450 may be made of a metal material or a material such as graphite. In addition to this, the sheet member 450 may be formed of various materials which shield electromagnetic waves and have heat conduction properties. Accordingly, the heat generated in the electronic component 420 may be transferred to the shield can 430 via the contact member 440 and the sheet member 450 to be diffused around the shield can 430.

According to various embodiments, the first heat transfer member 461 and the second heat transfer member 462 may be disposed on the sheet member 450. The first heat transfer member 461 and the second heat transfer member 462 may be formed of a material having excellent heat conduction efficiency, such as thermal interface material (TIM). In an embodiment, referring to FIGS. 6A to 6C, which will be described later, the first heat transfer member 461 and the second heat transfer member 462 may be covered with the cover member 470. Here, the cover member 470 may be a rear plate 380 (e.g., a rear cover) that constitutes the rear exterior of the electronic apparatus 400. The cover member 470 may be made of a material having excellent heat conduction efficiency, such as a metal material. Accordingly, the heat generated in the electronic component 420 may be transferred to the cover member 470 via the contact member 440, the sheet member 450, the first heat transfer member 461, and the second heat transfer member 462 to be released outside of the electronic apparatus 400.

According to an embodiment disclosed herein, the heat generated in the electronic component 420 may be transferred to the shield can 430 via the contact member 440 and the sheet member 450 to be diffused around the shield can 430. In addition, the heat generated in the electronic component 420 may be transferred to the cover member 470 via the contact member 440, the sheet member 450, the first heat transfer member 461, and the second heat transfer member 462 to be released outside of the electronic apparatus 400. Accordingly, the heat generation of the electronic component 420 may be alleviated or eliminated through the heat dissipation path described above, thereby preventing the performance of the electronic component 420 from deteriorating. Hereinafter, the configuration of the heat dissipation structure 401 disclosed herein will be described in detail.

FIG. 6A is a cross-sectional view taken along line A-A of FIG. 5. FIG. 6B is a cross-sectional view taken along line B-B of FIG. 5. FIG. 6C is a cross-sectional view taken along line C-C of FIG. 5.

According to various embodiments, the first heat transfer member 461 and the second heat transfer member 462 may be arranged to be spaced apart from each other. In an embodiment, referring to FIG. 6A, the first heat transfer member 461 may be located in a first direction (e.g., +X direction in FIG. 4) with respect to the center of the opening 431, and at least a portion thereof may be disposed in the second region 452 of the sheet member 450. The second heat transfer member 462 may be located in a second direction (e.g., -X direction in FIG. 4) opposite to the first direction with respect to the center of the opening 431, and at least a portion thereof may be disposed in the second region 452 of the sheet member 450.

In an embodiment, the first heat transfer member 461 and the second heat transfer member 462 may be disposed only in the second region 452 of the sheet member 450. In this case, the first heat transfer member 461 and the second heat transfer member 462 may be supported in the -Z direction in FIG. 6A through the shield can 430 to be structurally stable. In addition, the second region 452 of the sheet member 450 may not be pressed by the first heat transfer member 461 and the second heat transfer member 462 which are disposed only in the second region 452 of the sheet member 450. For example, when, due to an external impact applied to the cover member 470 (e.g., the rear plate 380 of FIG. 3), the external impact is transferred to the first heat transfer member 461 and the second heat transfer member 462, the first heat transfer member 461 and the second heat transfer member 462 may not press the first region 451 of the sheet member 450. Accordingly, an external impact may not be applied to the electronic component 420 covered in the first region 451 of the sheet member 450, or the degree of the external impact applied to the electronic component 420 may be alleviated.

In an embodiment, referring to FIG. 6A, the first heat transfer member 461 and the second heat transfer member 462 may extend from the second region 452 to the first region 451 of the sheet member 450. The first heat transfer member 461 and the second heat transfer member 462 may be at least partially disposed in the first region 451 when viewed in the +Z direction in FIG. 6A, so as not to overlap an adhesive member and/or an electronic component located in the first region 451 of the sheet member 450. In this case, the contact area of the first heat transfer member 461 and the second heat transfer member 462 with the cover member 470 and the sheet member 450 may be greater than when the first heat transfer member 461 and the second heat transfer member 462 are disposed only in the second region 452 of the sheet member 450. Accordingly, the amount of heat dissipation of the electronic component 420 through the first heat transfer member 461 and the second heat transfer member 462 may increase. In addition, since the first heat transfer member 461 and the second heat transfer member 462 do not overlap the contact member 440, the first heat transfer member 461 and the second heat transfer member 462 may not press the contact member 440 when an external impact is applied to the cover member 470. Accordingly, the external impact may not be applied to the electronic component 420 coupled to the sheet member 450 through the contact member 440.

In an embodiment, when the first heat transfer member 461 and the second heat transfer member 462 are at least partially disposed in the second region 452 of the sheet member 450, the first heat transfer member 461 and the second heat transfer member 462 may be supported by one surface of the shield can 430 surrounding the opening 431. In addition, when the first heat transfer member 461 and the second heat transfer member 462 are arranged to face each other, the structural stability of the cover member 470 supported through the first heat transfer member 461 and the second heat transfer member 462 may be ensured.

According to various embodiments, the first heat transfer member 461 and the second heat transfer member 462 may be formed of an elastic heat conductive material. When an external impact is applied to the cover member 470, the first heat transfer member 461 and the second heat transfer member 462 may be compressed, and the cover member 470 spaced apart from the sheet member 450 in the -Z direction in FIG. 6A may press the sheet member 450. For example, the cover member 470 may press the first region 451 of the sheet member 450. Accordingly, an external impact may be applied to the electronic component 420 coupled to the sheet member 450 through the contact member 440. In various embodiments disclosed herein, the cover member 470 may be supported through a protrusion part 480. The protrusion part 480 may support the cover member 470 to space the cover member 470 apart from the sheet member 450 in the -Z direction in FIG. 6B. Therefore, the pressure on the sheet member 450 by the cover member 470 due to external impact may be alleviated. This will be explained in detail below.

According to various embodiments, as shown in FIGS. 6B and 6C, the protrusion part 480 may be formed integrally with the cover member 470. For example, the protrusion part 480 may be a structure that protrudes from the cover member 470 in the +Z direction in FIG. 6C. In an embodiment, when no external impact is applied to the cover member 470, the protrusion part 480 may be spaced apart from the sheet member 450 in the -Z direction in FIG. 6A. In this case, the protrusion part 480 may overlap the second region 452 of the sheet member 450 when viewed in the direction of the printed circuit board 410 from the cover member 470 (the +Z direction in FIG. 6A). In an embodiment, when an external impact is applied to the cover member 470, the cover member 470 may be pressed in the +Z direction in FIG. 6A, and thus the protrusion part 480 may be brought into contact with the second region 452 of the sheet member 450. In this case, the cover member 470 may be supported on the shield can 430 through the protrusion part 480 and thus be spaced apart from the sheet member 450 in the -Z direction in FIG. 6A. Accordingly, when an external impact is applied to the cover member 470, the cover member 470 may not press the first region 451 of the sheet member 450. Therefore, the external impact being applied to the electronic component 420 in contact with the contact member 440 located in the first region 451 of the sheet member 450 may be alleviated or eliminated.

In another embodiment not shown in the drawings, the protrusion part 480 may be disposed separately from the cover member 470. The protrusion part 480 may be disposed in the second region 452 of the sheet member 450. In an embodiment, when no external impact is applied to the cover member 470, the protrusion part 480 may be spaced apart from the cover member 470 in the +Z direction in FIG. 6A. In an embodiment, when an external impact is applied to the cover member 470, the cover member 470 may be pressed in the +Z direction in FIG. 6A, and thus the protrusion part 480 may be brought into contact with the cover member 470. In this case, the protrusion part 480 may be disposed in the second region 452 of the sheet member 450 to support the cover member 470. The cover member 470 may be supported on the shield can 430 through the protrusion part 480 to be spaced apart from the first region 451 of the sheet member 450 in the -Z direction in FIG. 6A. Accordingly, when an external impact is applied to the cover member 470, the cover member 470 may not press the first region 451 of the sheet member 450. Therefore, the external impact being applied to the electronic component 420 in contact with the contact member 440 located in the first region 451 of the sheet member 450 may be alleviated or eliminated.

When an external impact is applied to the cover member 470, the external impact may be distributed throughout the shield can 430 via the protrusion part 480. Accordingly, the intensity of the external impact applied to the inside of the electronic apparatus 400 (e.g., the electronic apparatus 101 of FIG. 1, the electronic apparatus 200 of FIGS. 2A and 2B, and/or the electronic apparatus 300 of FIG. 3) may decrease. Therefore, the external impact may be prevented from being directly transferred to the electronic component 420, thereby protecting the electronic component 420 from the external impact.

In an embodiment, the protrusion part 480 may be disposed in the second region 452 of the sheet member 450 so as not to be in contact with the first heat transfer member 461 and the second heat transfer member 462. For example, referring to FIG. 5, the protrusion part 480 may be disposed between the first heat transfer member 461 and the second heat transfer member 462. In addition, the protrusion part 480 may be disposed at various positions within the second region 452 of the sheet member 450 so as not to be in contact with the first heat transfer member 461 and the second heat transfer member 462.

According to various embodiments, the printed circuit board 410 (e.g., the board 340 of FIG. 3) may include a first printed circuit board 411 and a second printed circuit board 412. In an embodiment, referring to FIGS. 6A to 6C, the electronic components 420 may be disposed on the first printed circuit board 411. The second printed circuit board 412 may include a groove 413 configured to accommodate the electronic component 420. The second printed circuit board 412 may be stacked on the first printed circuit board 411 in the -Z direction such that the electronic component 420 is accommodated in the groove 413.

In an embodiment, the shield can 430 may be disposed on the second printed circuit board 412. The shield can 430 may be disposed on the second printed circuit board 412 to cover the electronic component 420 disposed on the first printed circuit board 411. In addition, a support structure 510 and/or a dummy structure 520, which will be described with reference to FIGS. 7A and 7B, may be disposed on the second printed circuit board 412. The support structure 510 may be disposed between the second printed circuit board 412 and the shield can 430 to support the shield can 430. Furthermore, the dummy structure 520, which will be described later, may be disposed between the second printed circuit board 412 and the shield can 430 to support the shield can 430.

FIG. 7A illustrates the shield can 430, the electronic component 420, and the printed circuit board 410, which are combined with each other, according to various embodiments disclosed herein. FIG. 7B is a perspective view of the rear of the shield can 430 according to various embodiments disclosed herein.

According to various embodiments, as shown in FIG. 6A described above, the support structure 510 may be disposed between the shield can 430 and the printed circuit board 410 (e.g., the substrate 340 of FIG. 3). The support structure 510 may be disposed between the shield can 430 and the printed circuit board 410 to support the shield can 430 in the -Z direction in FIG. 6A. In an embodiment, referring to FIGS. 6A and 6C described above, the support structure 510 may be disposed on the second printed circuit board 412 stacked on the first printed circuit board 411. The support structure 510 may protect the shield can 430 from the external impact applied to the electronic apparatus 400 (e.g., the electronic apparatus 101 of FIG. 1, the electronic apparatus 200 of FIGS. 2A and 2B, and/or the electronic apparatus 300 of FIG. 3). When an external impact is applied to the cover member 470 (e.g., the rear plate 380 of FIG. 3), the external impact may be transferred to the shield can 430 through the first heat transfer member 461 and the second heat transfer member 462. In addition, the external impact transferred from the cover member 470 to the protrusion part 480 may be transferred to the shield can 430. The support structure 510 may support the shield can 430 to protect the shield can 430 from external impact. Accordingly, the shield can 430 may ensure durability against external impact through the support structure 510.

In an embodiment, the support structure 510 may be manufactured as a separate structure and placed between the shield can 430 and the printed circuit board 410 (e.g., the second printed circuit board 412). In this case, the support structure 510 may have one end coupled to the shield can 430 and the other end in contact with the printed circuit board 410 (e.g., the second printed circuit board 412). In contrast, the support structure 510 may have one end coupled to the printed circuit board 410 (e.g., the second printed circuit board 412) and the other end in contact with the shield can 430. The support structure 510 may be disposed between the shield can 430 and the printed circuit board 410 to surround the opening 431 formed through the shield can 430. Accordingly, the portion of the shield can 430 adjacent to the opening 431 may ensure durability against external impact.

In an embodiment, the support structure 510 may be formed integrally with the shield can 430. Referring to FIGS. 7A and 7B, the support structure 510 may be bent from one surface of the shield can 430 to extend toward the printed circuit board 410. For example, the support structure 510 may be bent toward the printed circuit board 410 from a surface surrounding the opening 431 to be in contact with the printed circuit board 410 (e.g., the second printed circuit board 412). The support structure 510 may be bent from one side of the shield can 430 to surround the opening 431. Accordingly, the portion of the shield can 430 adjacent to the opening 431 may ensure durability against external impact.

In an embodiment, an area for disposing the support structure 510 may not be secured in the shield can 430. In this case, as shown in FIG. 7A, the dummy structure 520 may be placed in a portion where the support structure 510 is not allowed to be disposed. The dummy structure 520 may be manufactured separately from the shield can 430 and placed between the shield can 430 and the printed circuit board 410. For example, the dummy structure 520 may be disposed on the second printed circuit board 412. Accordingly, the support structure 510 and the dummy structure 520 may support the shield can 430 to ensure durability of the shield can 430 against external impact.

In an embodiment, the dummy structure 520 may be a structure made of a material having a certain level of strength or higher to support the shield can 430 from external impact. In another embodiment, the dummy structure 520 may be an electrical structure that is disposed on the printed circuit board 410 and is not electrically connected to the printed circuit board 410.

In various embodiments disclosed herein, when an external impact is applied to the cover member 470, the external impact may be transferred to the shield can 430 through the first heat transfer member 461 and the second heat transfer member 462. In addition, the external impact transferred from the cover member 470 to the protrusion part 480 may be transferred. The support structure 510 and the dummy structure 520 may support the shield can 430 to ensure durability of the shield can 430 against the external impact. For example, when the shield can 430 is pressed in the +Z direction in FIG. 6A by an external impact, the support structure 510 and the dummy structure 520 may support the shield can 430 in the -Z direction in FIG. 6A to prevent the shield can 430 from being pressed. Accordingly, the shape of the shield can 430 may not be deformed by the external impact. In addition, the electronic component 420 located inside the shield can 430 may be protected from the external impact.

The electronic apparatus 400 (the electronic apparatus 101 of FIG. 1, the electronic apparatus 200 of FIGS. 2A and 2B, and/or the electronic apparatus 300 of FIG. 3) according to various embodiments disclosed herein may include a printed circuit board 410 (e.g., the board 340 of FIG. 3), an electronic component 420 disposed on the printed circuit board, a shield can 430 disposed on the printed circuit board and including an opening 431 facing at least a portion of the electronic component, a support structure 510 (e.g., the support structure 510 and/or the dummy structure 520 of FIG. 7A) disposed between the printed circuit board and the shield can and configured to support the shield can, a contact member 440 at least partially located in the opening and configured to cover a portion of the electronic component, a sheet member 450 including a first region 451 which corresponds to the opening, and a second region 452 other than the first region, and configured to cover the contact member and the shield can, a first heat transfer member 461 disposed on the sheet member, a second heat transfer member 462 disposed on the sheet member and spaced apart from the first heat transfer member, a cover member 470 (e.g., the rear plate 380 of FIG. 3) configured to cover the first heat transfer member and the second heat transfer member, and a protrusion part 480 overlapping the second region of the sheet member when viewed in the direction of the printed circuit board (e.g., the +Z direction in FIG. 6A) from the cover member.

The first heat transfer member and the second heat transfer member may be disposed in the second region of the sheet member.

The first heat transfer member and the second heat transfer member may be at least partially disposed in the second region of the sheet member to extend to the first region.

The first heat transfer member and the second heat transfer member may be disposed on the sheet member so as not to overlap the contact member when viewed in the direction of the printed circuit board (e.g., the +Z direction in FIG. 6A) from the cover member.

The support structure may be formed integrally with the shield can.

The support structure may be bent from one surface of the shield can to extend toward the printed circuit board.

The support structure may be arranged to surround the opening formed through the shield can.

The protrusion part may be formed integrally with the cover member.

The cover member may be spaced apart from the first region of the sheet member.

The printed circuit board may include a first printed circuit board 411 on which the electronic component is disposed, and a second printed circuit board 412 disposed on the first printed circuit board and including a groove 413 configured to receive the electronic component, and the shield can may be disposed on the second printed circuit board.

The support structure may be disposed between the shield can and the second printed circuit board.

The protrusion part may be disposed between the first heat transfer member and the second heat transfer member.

The heat dissipation structure 401 according to various embodiments disclosed herein may include a shield can 430 disposed on the printed circuit board and including an opening 431 facing at least a portion of the electronic component 420 disposed on the printed circuit board 410 (e.g., the substrate 340 of FIG. 3) of the electronic apparatus 400 (the electronic apparatus 101 of FIG. 1, the electronic apparatus 200 of FIGS. 2A and 2B, and/or the electronic apparatus 300 of FIG. 3), a support structure 510 disposed between the printed circuit board and the shield can to support the shield can (e.g., the support structure 510 and/or the dummy structure 520 of FIG. 7A), a contact member 440 at least partially located in the opening and configured to cover a portion of the electronic component, a sheet member 450 including a first region 451 which corresponds to the opening, and a second region 452 other than the first region, and configured to cover the contact member and the shield can, a first heat transfer member 461 disposed on the sheet member, a second heat transfer member 462 disposed on the sheet member and spaced apart from the first heat transfer member, a cover member 470 (e.g., the rear plate 380 of FIG. 3) configured to cover the first heat transfer member and the second heat transfer member, and a protrusion part 480 overlapping the second region of the sheet member when viewed in the direction of the printed circuit board (e.g., the +Z direction based in FIG. 6A) from the cover member.

The first heat transfer member and the second heat transfer member may be disposed in a second region of the sheet member.

The first heat transfer member and the second heat transfer member may be at least partially disposed in the second region of the sheet member to extend to the first region.

The first heat transfer member and the second heat transfer member may be disposed on the sheet member so as not to overlap the contact member when viewed in the direction of the printed circuit board (e.g., the +Z direction in FIG. 6A) from the cover member.

The support structure may be bent from one surface of the shield can to extend toward the printed circuit board.

The support structure may be disposed to surround the opening formed through the shield can.

The protrusion part may be formed integrally with the cover member.

The cover member may be spaced apart from the first region of the sheet member.

The embodiments provided in the disclosure provided in the specification and drawings are merely presented as specific examples to easily explain the technical content according to the embodiments provided in the disclosure and to help understanding of the embodiments provided in the disclosure, and are not intended to limit the scope of the embodiment of the disclosure. Therefore, the scope of the various embodiments in the disclosure should be interpreted that, in addition to the embodiments disclosed herein, all changes or modifications derived from the technical ideas of the various embodiments in the disclosure are included in the scope of the various embodiments in the disclosure.

## Claims

1. An electronic apparatus comprising:
a printed circuit board;
an electronic component disposed on the printed circuit board;
a shield can disposed on the printed circuit board and comprising an opening facing at least a portion of the electronic component;
a support structure disposed between the printed circuit board and the shield can and configured to support the shield can;
a contact member at least partially located in the opening and configured to cover a portion of the electronic component;
a sheet member comprising a first region which corresponds to the opening, and a second region other than the first region and configured to cover the contact member and the shield can;
a first heat transfer member disposed on the sheet member;
a second heat transfer member disposed on the sheet member and spaced apart from the first heat transfer member;
a cover member configured to cover the first heat transfer member and the second heat transfer member; and
a protrusion part overlapping the second region of the sheet member when viewed in the direction of the printed circuit board from the cover member.

2. The electronic apparatus of claim 1, wherein the first heat transfer member and the second heat transfer member are disposed in the second region of the sheet member.

3. The electronic apparatus of claim 1, wherein the first heat transfer member and the second heat transfer member are at least partially disposed in the second region of the sheet member to extend to the first region.

4. The electronic apparatus of claim 1, wherein the first heat transfer member and the second heat transfer member are disposed on the sheet member so as not to overlap the contact member when viewed in the direction of the printed circuit board from the cover member.

5. The electronic apparatus of claim 1, wherein the support structure is formed integrally with the shield can.

6. The electronic apparatus of claim 1, wherein the support structure is bent from one surface of the shield can to extend toward the printed circuit board.

7. The electronic apparatus of claim 1, wherein the support structure is disposed to surround the opening formed through the shield can.

8. The electronic apparatus of claim 1, wherein the protrusion part is formed integrally with the cover member.

9. The electronic apparatus of claim 1, wherein the cover member is spaced apart from the first region of the sheet member.

10. The electronic apparatus of claim 1, wherein the printed circuit board comprises a first printed circuit board on which the electronic component is disposed, and a second printed circuit board disposed on the first printed circuit board and comprising a groove configured to receive the electronic component, and
wherein the shield can is disposed on the second printed circuit board.

11. The electronic apparatus of claim 10, wherein the support structure is disposed between the shield can and the second printed circuit board.

12. The electronic apparatus of claim 1, wherein the protrusion part is disposed between the first heat transfer member and the second heat transfer member.

13. A heat dissipation structure comprising:
a shield can disposed on a printed circuit board of an electronic apparatus and comprising an opening facing at least a portion of an electronic component disposed on the printed circuit board;
a support structure disposed between the printed circuit board and the shield can to support the shield can;
a contact member at least partially located in the opening and configured to cover a portion of the electronic component;
a sheet member comprising a first region which corresponds to the opening, and a second region other than the first region, and configured to cover the contact member and the shield can;
a first heat transfer member disposed on the sheet member;
a second heat transfer member disposed on the sheet member and spaced apart from the first heat transfer member;
a cover member configured to cover the first heat transfer member and the second heat transfer member; and
a protrusion part overlapping the second region of the sheet member when viewed in the direction of the printed circuit board from the cover member.

14. The heat dissipation structure of claim 13, wherein the first heat transfer member and the second heat transfer member are disposed in a second region of the sheet member.

15. The heat dissipation structure of claim 13, wherein the support structure is bent from one surface of the shield can to extend toward the printed circuit board.
